# EUROPEAN PATENT APPLICATION

(11) **EP 2 679 537 A1**
(43) Date of publication of application: **01.01.2014**
(21) Application number: 12173761.3
(22) Date of filing: 27.06.2012
(51) Int. Cl.: B81C 1/00

(54) **Method for producing metal lines on top of a non-flat mems topography**

(71) Applicant: IMEC, 3001 Leuven (BE)
(72) Inventor: Severi, Simone, 3001 Leuven (BE); Van Hoof, Rita, 3001 Leuven (BE)
(74) Representative: Clerix, André

(57) **Abstract**

The present disclosure is related to a method for producing one or more structural elements (3,4) on top of at least two components of a Micro-Electromechanical System (MEMS) device, wherein a gap (10) is present between two of said components, the method comprising:
● filling said gap with a planarizing material,
● producing said elements on top of said two components (1,2),

wherein filling said gap (10) consists of performing subsequently:
● a first step, being a sputtering step or a combined sputtering/deposition step, thereby widening the entrance to said gap, and,
● a second step, being a conformal deposition step, thereby filling said gap with a planarizing material and producing a substantially flat layer (17) of said material on top of said components (1,2).

## Description

### Field of the Disclosure

The present disclosure is related to Micro-Electromechanical Systems (MEMS) devices, and in particular to the application of conductor lines on a MEMS structure having a given topography variation. The MEMS structure can be for example a bar-resonator and the conductor lines standing on top of the MEMS structure can be used for temperature sensing.

### State of the art

In some applications, the functionality of a MEMS device requires structural elements to be built up on top of a number of components of the device. For example, it may be necessary to produce a metal line connecting two components of the MEMS device, for example a membrane and a bond pad., These structural elements may need to be formed on a certain non-flat topography. For example, a deep trench may be present between the membrane and the bond pad. For producing the metal line on such a MEMS device, the topography needs to be removed: a flat surface is required to guarantee a reproducible definition of the structures and a reliable etching process in the lithography steps applied for producing the metal lines.

It is known to obtain the required flat surface by filling the trenches with an oxide and performing a Chemical Mechanical polishing step. When the topography variation is larger than a few microns, this technique represents a technical challenge both when the trench is very narrow and when it is very wide. For narrow trenches, e.g. 200nm wide, a large empty keyhole is formed up to the surface. The CMP slurry can penetrate into this void at the end of the polishing step, causing the failure of the MEMS device after release. A very wide trench on the other hand requires an oxide thickness of 1.5 times its depth in order to be properly filled and planarized. This results in long oxide deposition times, long CMP times and high slurry consumption as well as high within-wafer nonuniformity. The choice of the planarizing material also needs to be compatible with the MEMS release process (wet or vapour HF etch for example), i.e. it has to be removed with high selectivity towards the MEMS structural layer material.

### Summary of the disclosure

The disclosure aims to provide a method suitable for filling and planarizing a very narrow gap between MEMS-components, e.g. a gap of maximum 2micron in width, while the depth of the gap is higher than a few microns e.g. higher than 2µm. The method is for example suitable for planarizing a topology with gaps of 4µm deep and 200nm wide. This aim is achieved by the method according to the appended claims.

The disclosure is thus related to a method for producing one or more structural elements on top of at least two components of a Micro-Electromechanical System (MEMS) device, wherein a gap is present between two of said components, the method comprising the steps of:
- Filling said gap with a planarizing material,
- producing said elements on top of said two components, wherein filling said gap consists of performing subsequently:
- a first step, being a sputtering step or a combined sputtering/deposition step, thereby widening the entrance to said gap,
- a second step, being a conformal deposition step, thereby filling said gap with a planarizing material and producing a substantially flat layer of said material on top of said components.

According to an embodiment, said first step is a combined sputtering/deposition step, performed by High Density Plasma deposition of the planarizing material. The second step may be performed by Sub-Atmospheric Chemical Vapour Deposition (SACVD). According to an embodiment, said gap is maximum 2 micron wide and more than 2 micron deep.

According to an embodiment, the method further comprises a Chemical-Mechanical Polishing step to thin down or remove a portion of said flat layer of the planarizing material, said portion extending above the top surface of said components. Alternatively, the method may further comprise a dry or wet etching step to thin down or remove a portion of said flat layer of the planarizing material, said portion extending above the top surface of said components.

According to an embodiment, said one or more structural elements comprise an insulating layer and one or more metal lines.

### Brief description of the figures

Figure 1 shows an example of a MEMS device to which the method of the disclosure is applicable.

Figure 2 illustrates the steps of the method according to the disclosure.

### Detailed description of the disclosure

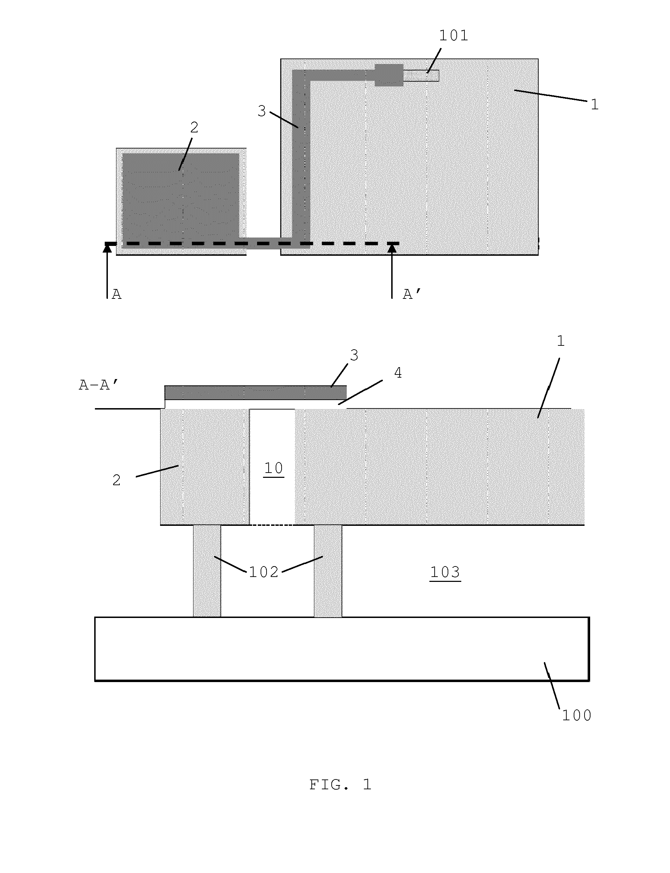

Figure 1 shows the MEMS device comprising a membrane 1 and bond pad 2 referred to above, constructed on a base substrate 100, e.g. a silicon wafer. The metal line 3 connects the bond pad to a sensor location 101, for example a piezo-resistor. The metal line is isolated from the MEMS device by an insulating layer 4. The production of the components 1 and 2 involves known manufacturing steps performed on the base substrate 100, involving the creation of contact vias 102, embedded in a layer 103 of a dielectric, e.g. silicon oxide, and the creation of gaps 10 for defining the structural elements 1, 2.

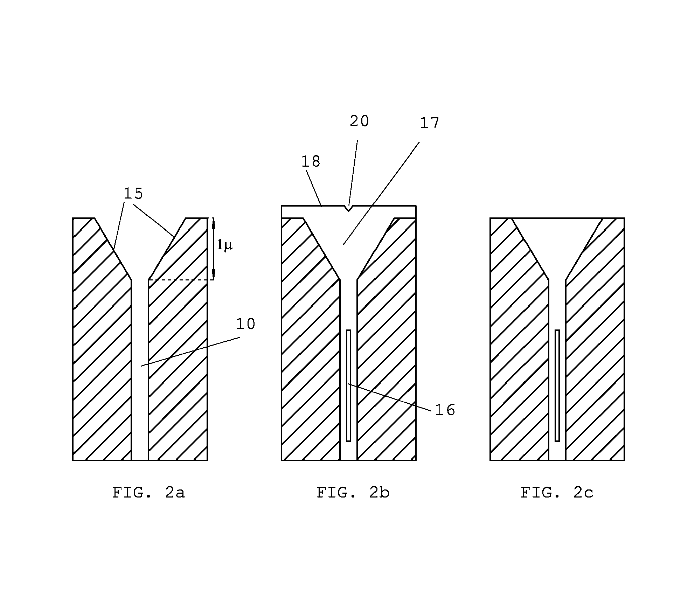

In order to correctly produce the insulating layer 4 and the conductive line 3, the gap 10 between the bond pad and the membrane needs to be filled with a suitable planarizing material, which can be the same material as layer 103, e.g. Si-oxide, though other materials may be used as well. According to the disclosure, this filling is done in two steps, as illustrated in figure 2 for a narrow gap, e.g. 200nm wide:
- First a sputtering step (fig. 2a), possibly a combined sputtering/deposition step, is performed. This step causes the sputtering of the edges of the gap, thereby widening the gap at the top by forming slanted side edges 15, e.g. up to a depth of about 1µm, as indicated in the drawing. When a combined sputtering/deposition step is applied, a thin layer of the planarizing material gets deposited on the top surface of the MEMS components and on the slanted side edges 15. A suitable technique of the latter type is High Density Plasma (HDP) sputtering.
- Then a conformal deposition step is performed, thereby depositing a conformal layer of the planarizing material in the gap 10 and on the top surface of the MEMS components. 'Conformal' means that substantially the same thickness is deposited on every exposed surface. The result is that the gap is filled and that a substantially flat layer with a constant thickness is formed on top of the MEMS components, possibly with a small trench 20 remaining above the center line of the gap (figure 2b). A suitable conformal deposition technique is Sub-Atmospheric Chemical Vapour Deposition (SACVD) deposition.

The filling of the gap by the conformal deposition step may still create a keyhole 16 but this keyhole is buried deeper in the gap thanks to the wider entrance to this gap. As the second deposition is a conformal deposition, it is possible to fill the gap so as to obtain a layer 17 of the planarizing material with a flat or substantially flat surface 18 on the MEMS device. A CMP step is then no longer strictly required, as the production of the metal lines can take place directly on the flat surface 18. Optionally, a brief CMP step can be performed in order to reduce the thickness of the portion of the layer 17 that is extending above the top surface of the MEMS components or to completely remove said portion before producing the metal line 3. Alternatively, it is possible to thin down or remove said portion of layer 17 that is extending above the MEMS components' top surface by a suitable wet or dry etching step.

Hereafter a number of examples are given of process parameters and materials that are suitable for use in the method of the disclosure. The planarizing material can be SiO₂. Alternatively, it can be a polymer. In the latter case, the sputtering step is not combined with deposition of the polymer. The polymer is deposited during the conformal deposition step, for example by a spin-on technique. The precursor used during HDP deposition of SiO₂ can be SiH₄, applied together with O₂ and Ar. For SACVD deposition of SiO₂, the precursor can be Tetra-ethyl ortho silicate (TEOS). The process parameters used during HDP deposition of SiO₂ can be for example: pressure < 10mTorr, temperature about 400°C, deposition time of a few minutes. The process parameters used during and SACVD deposition of SiO₂ can be: pressure < 10mTorr, temperature about 420°C, deposition time of a few minutes. HDP and SACVD deposition can be performed for example in the Centura platform, from Applied Materials.

The method of the disclosure is suitable both for producing structural elements that are a part of the final MEMS device, and for post-processing structural elements on a previously finished MEMS device.

While the disclosure has been illustrated and described in detail in the drawings and foregoing description, such illustration and description are to be considered illustrative or exemplary and not restrictive. Other variations to the disclosed embodiments can be understood and effected by those skilled in the art in practicing the claimed disclosure, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

The foregoing description details certain embodiments of the disclosure. It will be appreciated, however, that no matter how detailed the foregoing appears in text, the disclosure may be practiced in many ways, and is therefore not limited to the embodiments disclosed. It should be noted that the use of particular terminology when describing certain features or aspects of the disclosure should not be taken to imply that the terminology is being re-defined herein to be restricted to include any specific characteristics of the features or aspects of the disclosure with which that terminology is associated.

Unless specifically specified, the description of a layer being deposited or produced 'on' another layer or substrate, includes the options of
- said layer being produced or deposited directly on, i.e. in contact with, said other layer or substrate, and
- said layer being produced on one or a stack of intermediate layers between said layer and said other layer or substrate.

## Claims

1. A method for producing one or more structural elements (3,4) on top of at least two components of a Micro-Electromechanical System (MEMS) device, wherein a gap (10) is present between two of said components, the method comprising:
• filling said gap with a planarizing material,
• producing said elements on top of said two components (1,2),
wherein filling said gap (10) consists of performing subsequently:
• a first step, being a sputtering step or a combined sputtering/deposition step, thereby widening the entrance to said gap, and,
• a second step, being a conformal deposition step, thereby filling said gap with a planarizing material and producing a substantially flat layer (17) of said material on top of said components (1,2).

2. Method according to claim 1, wherein said first step is a combined sputtering/deposition step, performed by High Density Plasma deposition of the planarizing material.

3. Method according to claim 1 or 2, wherein the second step is performed by Sub-Atmospheric Chemical Vapour Deposition (SACVD).

4. Method according to any one of the preceding claims, wherein said gap (10) is maximum 2 micron wide and more than 2 micron deep.

5. Method according to any one of the preceding claims, further comprising a Chemical-Mechanical Polishing step to thin down or remove the portion of said flat layer (17) of the planarizing material, said portion extending above the top surface of said components (1,2).

6. Method according to any one of claims 1 to 4, further comprising a dry or wet etching step to thin down or remove the portion of said flat layer (17) of the planarizing material, said portion extending above the top surface of said components (1,2).

7. Method according to any one of the preceding claims, wherein said one or more structural elements comprise an insulating layer (4) and one or more metal lines (3).
